# DEMANDE DE BREVET EUROPEEN

(11) **EP 1 104 019 A1**
(43) Date de publication de la demande: **30.05.2001**
(21) Numéro de dépôt: 00403164.7
(22) Date de dépôt: 14.11.2000
(51) Int. Cl.: H01L 21/66, H01J 37/32

(54) **Procédé et dispostif de contrôle en temps réel de l'épaisseur d'une couche d'un circuit intégré**

(30) Priorité: 23.11.1999 FR 9914723
(71) Demandeur: ATMEL NANTES SA, 44300 Nantes (FR)
(72) Inventeur: Charpentier, Alain, 44000 Nantes (FR); Bocquène, Dominique, 44470 Carquefou (FR)
(74) Mandataire: Fréchède, Michel

(57) **Abrégé**

L'invention concerne un procédé et un dispositif de mesure de l'épaisseur d'une couche d'un circuit intégré.

La couche à mesurer étant déposée sur une couche sous-jacente, le procédé, au cours d'une opération de gravure, consiste à suivre (B) l'avancement du front de gravure par un tracé en temps réel du spectre d'émission optique du produit de la réaction de gravure sur une composante spectrale de la couche sous-jacente, à établir (C) une distribution temporelle de l'amplitude de l'émission optique du produit de la réaction de gravure, à déterminer (D) sur la distribution la transition de l'amplitude de l'émission optique lors du passage du front de gravure de la couche à mesurer à la couche sous-jacente et à calculer (E) à partir de la distribution et de la transition l'épaisseur de la couche à mesurer par corrélation à la transition sur la distribution précitée.

Application à la mise en oeuvre de processus industriels de fabrication de cellules mémoires de type EPROM.

## Description

L'invention est relative à un procédé et à un dispositif de contrôle en temps réel de l'épaisseur d'une couche de circuit intégré, au cours d'un processus de gravure.

Lors de la fabrication de circuits intégrés, il peut apparaître opportun de mesurer l'épaisseur d'une couche de ce circuit intégré déposée au cours d'étapes antérieures de mise en oeuvre de ce processus de fabrication.

C'est notamment le cas lors de la fabrication de cellules mémoires de type EPROM, la technologie mise en oeuvre imposant, de fait, la réalisation d'un empilement d'isolation entre deux couches conductrices désignées par grille de commande et grille flottante (*control gate* et *floating gate* en langage anglo-saxon) respectivement.

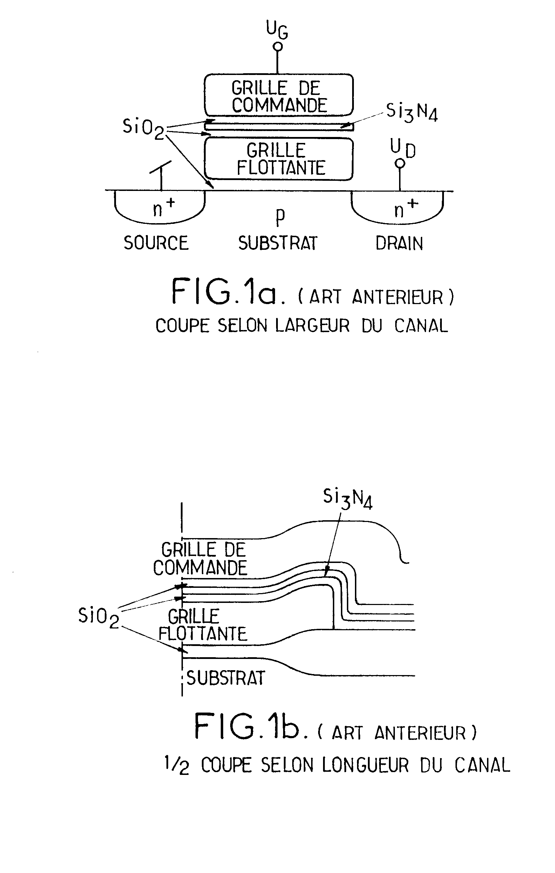

L'empilement réalisé, plus communément appelé ONO, pour Oxyde, Nitride, Oxyde, est constitué par une couche d'oxyde de silicium, SiO₂, d'une couche de nitrure de silicium, Si₃N₄, et d'une seconde couche d'oxyde de silicium, cet empilement étant pris en sandwich entre l'électrode flottante et l'électrode de grille. L'ensemble de la structure comprenant l'empilement précité déposé sur un substrat de silicium par exemple de type P, est isolé par l'intermédiaire d'une couche d'oxyde de silicium ainsi que représenté en figures 1a et 1b selon une vue en coupe suivant la largeur, respectivement la longueur du canal.

La structure et l'empilement ainsi réalisés constituent une partie du coeur de la cellule mémoire EPROM et permettent, notamment, la programmation par injection de charges électriques dans la première couche conductrice, la grille flottante, et la mémorisation de l'état de programmation ainsi réalisée par tenue, dans le temps, de la charge injectée.

L'épaisseur de la seconde couche d'oxyde de silicium, comprise entre la couche de nitrure de silicium Si3N4 et la grille de commande peut varier entre 20 et 50 Angströms, 1 Å = 10⁻¹⁰m, selon les technologies utilisées. Cette couche peut être réalisée par oxydation thermique classique ou par dépôt, quelle qu'en soit la nature.

Le contrôle de la qualité et de l'épaisseur de cette deuxième couche d'oxyde sont toutefois critiques car ils contribuent directement au premier ordre à garantir le non-vieillissement de la cellule mémoire réalisée, le non-vieillissement s'entendant de l'absence de perte de charges électriques après programmation. Pour une description plus détaillée de la corrélation existant entre le phénomène de vieillissement de ce type de cellule mémoire EPROM et l'épaisseur de silicium, on pourra utilement se reporter aux articles intitulés :
■ *Threshold Voltage Instability and Charge Retention in Non-volatile Memory Cell with Nitride/Oxide/Nitride double-layered Inter-poly Dielectric,* publié par Seiichi Mori et al. 1991/IEEE/IRPS ;
■ *Bottom-ox scaling for* thin *Nitride/oxide interpoly dielectric*, publié par Seiichi Mori et al. IEEE Transactions on Electronic Devices, Vol.39, N°2, Feb.1992 ;
■ *Thickness Scaling Limitations Factors of ONO Interpoly Dielectrics,* Seiichi Mori et al. IEEE Transactions on Electronic Devices, Vol.43, N°12, Jan.1996.

Actuellement, lors de la mise en oeuvre des processus de fabrication des cellules mémoires EPROM, le contrôle, nécessaire, de cette épaisseur est généralement effectué de manière déportée, via un témoin de silicium distinct sur un équipement de mesure approprié, c'est-à-dire en dehors du processus de fabrication effectué sur les plaques de production.
Ainsi, la technique de mesure précitée peut, outre la perte de temps de mise en oeuvre inhérente à une mesure en temps différé, présenter un problème majeur de fiabilité, car les cinétiques d'oxydation sur silicium et sur nitrure de silicium peuvent être très différentes. Ainsi, pour une même épaisseur d'oxyde de silicium réalisée sur un témoin de silicium, l'épaisseur correspondante d'oxyde de silicium peut varier d'un facteur 1 à 1/3, sur plaque de production.
En outre, la réalisation de cette couche d'oxyde de silicium nécessite d'utiliser un équipement de mesure performant permettant d'effectuer la mesure de cette couche sur ce témoin.

La présente invention a pour objet de remédier aux inconvénients précités de l'art antérieur par suppression de la mise en oeuvre d'un témoin de dépôt d'oxyde de silicium et par mise en oeuvre en temps réel d'un procédé de mesure de l'épaisseur d'une couche d'un circuit intégré au cours du processus de fabrication, notamment de gravure, de ce circuit intégré.

Le procédé de mesure en temps réel de l'épaisseur d'une couche d'un circuit intégré, cette couche, dite couche à mesurer, étant déposée sur une couche sous-jacente, est mis en oeuvre au cours d'une opération de gravure du substrat de ce circuit intégré incorporant ces couches.
Il est remarquable en ce qu'il consiste à suivre l'avancement du front de gravure de chaque couche du circuit intégré, par l'intermédiaire d'un tracé en temps réel du spectre d'émission optique du produit de la réaction de gravure sur au moins une composante spectrale de la couche sous-jacente, à établir, en fonction du temps, une distribution de l'amplitude de l'émission optique du produit de la réaction de gravure, et à déterminer, sur cette distribution, la transition de l'émission optique lors du passage du front de gravure de la couche à mesurer à la couche sous-jacente. L'épaisseur de la couche à mesurer est calculée à partir de cette distribution et de la transition, par corrélation à cette transition sur cette distribution.

Le procédé objet de la présente invention peut être appliqué à la mesure de l'épaisseur de couches de circuits intégrés déposées sur une couche sous-jacente de tout type, mais apparaît plus particulièrement adapté à la mesure de l'épaisseur de la deuxième couche d'oxyde de silicium déposée sur une couche sous-jacente de nitrure de silicium telles que celles qui sont mises en oeuvre dans les cellules EPROM à l'échelle industrielle.

Il sera mieux compris à la lecture de la description et à l'observation des dessins ci-après dans lesquels, outre les figures 1a et 1b relatives à l'art antérieur :
- la figure 2 représente, à titre purement illustratif, un organigramme des étapes de mise en oeuvre du procédé objet de la présente invention ;
- la figure 3 représente un diagramme de distribution temporelle de l'amplitude d'émission optique du produit de gravure pour une composante spectrale de la couche sous-jacente à la couche à mesurer constituée par du nitrure de silicium ;
- la figure 4 représente une loi d'étalonnage de l'épaisseur effective de la couche à mesurer en fonction du temps de gravure entre le début de la gravure et la transition d'amplitude de distribution, lorsque la couche à mesurer est de l'oxyde de silicium et la couche sous-jacente du nitrure de silicium ;
- la figure 5 représente le schéma d'une installation permettant la mise en oeuvre du procédé objet de la présente invention.

D'une manière générale, on indique que le procédé de mesure en temps réel de l'épaisseur d'une couche d'un circuit intégré peut être appliqué à la mesure de couches de toute nature au cours de la gravure d'un circuit intégré de type quelconque.

Ainsi, le circuit intégré ou le substrat support de ce dernier est placé dans un réacteur tel qu'un réacteur de type diode, l'excitation électromagnétique étant une excitation radiofréquence ou micro-onde, dans lequel une atmosphère de gravure appropriée a été créée. Le procédé objet de l'invention peut être mis en oeuvre à partir de tout équipement de gravure de type monoplaque contrôlé par un microprocesseur moyennant une adaptation matérielle, laquelle sera décrite ultérieurement dans la description.

Différentes indications relatives à une mise en oeuvre spécifique du procédé objet de la présente invention pour déterminer l'épaisseur de la deuxième couche d'oxyde SiO₂ d'une cellule mémoire de type EPROM seront toutefois données afin d'illustrer une mise en oeuvre particulière non limitative du procédé précité.

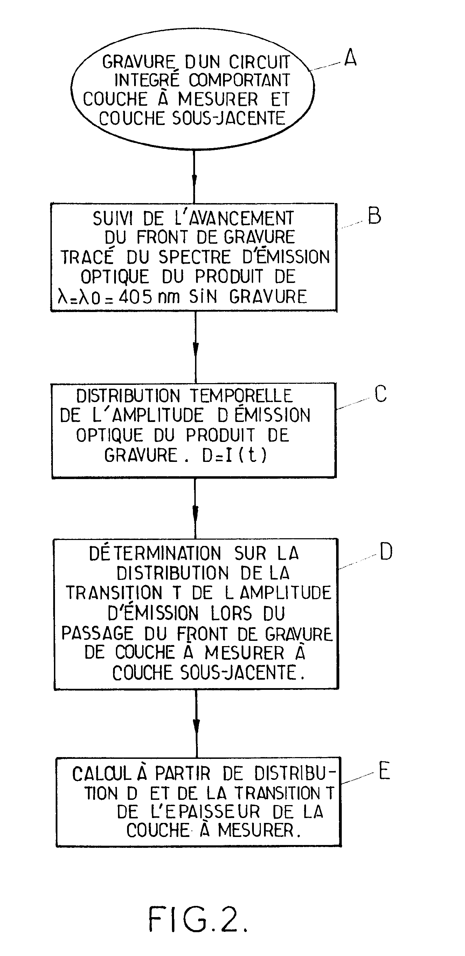

En référence à la figure 2, on indique que le circuit intégré ou le substrat support de celui-ci comporte une couche à mesurer et une couche sous-jacente, ce circuit intégré, à l'étape A, étant placé dans le réacteur de gravure précédemment mentionné.

En référence à la figure 2 précitée, le procédé objet de l'invention consiste, en une étape B, à suivre l'avancement du front de gravure de chaque couche de circuit intégré par l'intermédiaire d'un tracé en temps réel du spectre d'émission optique du produit de la réaction de gravure sur au moins une composante spectrale de la couche sous-jacente précitée. De manière plus spécifique, on indique que le front de gravure est constitué par la rencontre de l'atmosphère de gravure créée dans le réacteur, cette atmosphère de gravure étant l'atmosphère créée au cours du processus de gravure proprement dit dans les conditions de gravure précitées, avec la couche soumise au processus de gravure proprement dit. Le produit de la réaction de gravure consiste essentiellement en l'atmosphère de gravure, laquelle est sensiblement modifiée au cours de la rencontre successive des couches par le front de gravure précédemment mentionné.

Selon un aspect remarquable du procédé objet de la présente invention, la composante spectrale de la couche sous-jacente est déterminée par une longueur d'onde λ = λ₀ caractéristique de la couche sous-jacente précitée. Ainsi, l'émission optique du produit de la réaction de gravure pour la composante spectrale, c'est-à-dire la longueur d'onde précitée, permet de vérifier l'avancement du front de gravure dans la succession des couches rencontrées par ce dernier, ainsi qu'il sera décrit ci-après.

En ce qui concerne le spectre d'émission optique du produit de la réaction de gravure, on indique que celui-ci est établi pour l'amplitude de l'émission optique du produit de la réaction de gravure pour la composante spectrale précitée, c'est-à-dire la longueur d'onde λ = λ₀.

Dans ces conditions, l'étape B précitée est alors suivie d'une étape C consistant à établir en fonction du temps une distribution, notée D, de l'amplitude de l'émission optique du produit de la réaction de gravure précitée, cette distribution étant notée D = I(t).

Conformément à un aspect remarquable du procédé objet de la présente invention, celui-ci consiste ensuite, en une étape D, à déterminer, sur la distribution D précitée, la transition de l'amplitude de l'émission optique lors du passage du front de gravure de la couche à mesurer à la couche sous-jacente. Cette détermination permet ainsi de mesurer une valeur de temps à partir d'une origine de gravure, cette valeur de temps constituant une mesure de la durée pour l'atteinte par le front de gravure de la couche sous-jacente précitée. La transition T est définie à partir d'éléments numériques tenant compte notamment du front de montée de la transition notée T.

L'étape D est alors suivie d'une étape notée E, consistant à calculer, à partir de la distribution D et de la transition T, l'épaisseur de la couche à mesurer par corrélation à la position temporelle de cette transition sur la distribution D précitée.

Alors que la composante spectrale de la couche sous-jacente est une longueur d'onde λ₀ d'émission remarquable caractéristique de la couche sous-jacente précitée, on indique que lorsque la couche à mesurer est constituée par la deuxième couche d'oxyde de silicium et que la couche sous-jacente est constituée par une couche d'arrêt en nitrure de silicium telles que celles introduites dans les cellules mémoires EPROM précédemment mentionnées, la composante spectrale de la couche sous-jacente est la raie du nitrure de silicium à 405 nm.

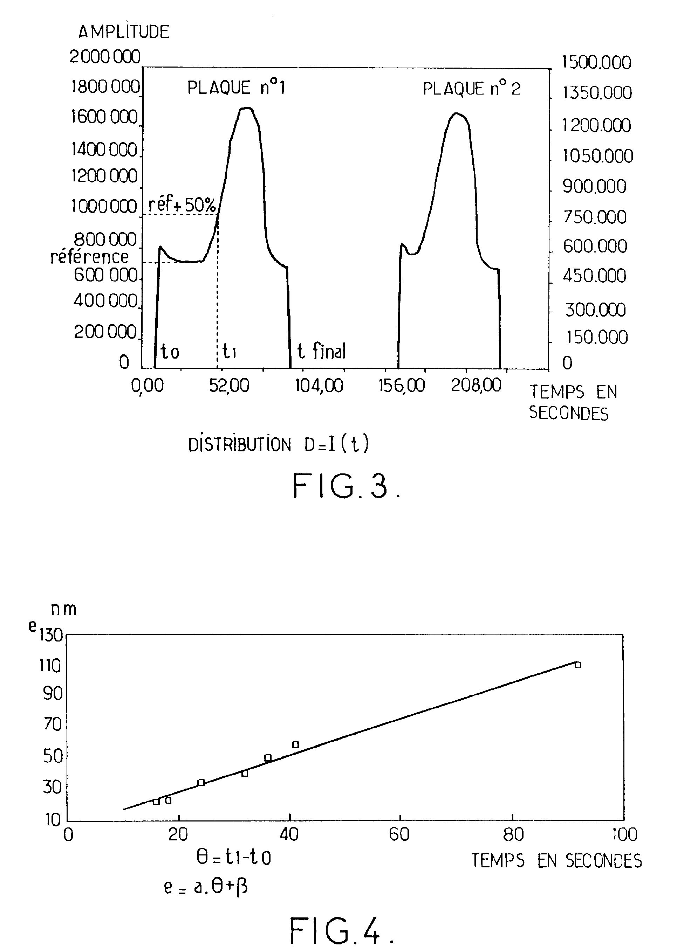

Une description plus détaillée de la mise en oeuvre des étapes C, D et E de mise en oeuvre du procédé telles que décrites en liaison avec la figure 2 sera maintenant donnée en liaison avec les figures 3 et 4 dans l'exemple non limitatif de la mesure de l'épaisseur de la deuxième couche d'oxyde de silicium précitée.

Dans une telle situation, le procédé objet de la présente invention est mis en oeuvre au cours de la réalisation de cellules EPROM, lesquelles nécessitent un nombre important d'étapes de fabrication, les étapes essentielles nécessaires étant simplement rappelées à titre illustratif en liaison avec les figures 1a et 1b.

Pour obtenir une cellule EPROM telle que représentée aux figures précitées, outre les étapes nécessaires de préparation du substrat de silicium, il faut en outre successivement effectuer :
a) la réalisation de la première couche d'oxyde de silicium ;
b) la réalisation de la couche d'arrêt de nitrure de silicium Si₃N₄ ;
c) la réalisation de la deuxième couche d'oxyde de silicium ;
d) l'étalement d'une résine photosensible ;
e) l'exposition par l'intermédiaire d'une machine photolithographique d'un réticule définissant les zones dans lesquelles l'on réalise l'empilement des couches de premier oxyde de silicium, de nitrure de silicium et de deuxième couche d'oxyde de silicium, conformément aux figures 1a et 1b précitées ;
f) le développement de la résine photosensible ;
g) la gravure dans un réacteur à plasma de l'empilement résiduel inutile, afin d'assurer la fonctionnalité de la cellule dans la configuration représentée en figures 1a et 1b.

Dans le cadre du processus de fabrication précité, le procédé objet de la présente invention consistant à contrôler l'épaisseur de la deuxième couche d'oxyde de silicium réalisée à l'étape c) est mis en oeuvre au cours de l'étape e) précédemment mentionnée.

En ce qui concerne l'étape B de suivi de l'avancement du front de gravure du procédé objet de l'invention, cette étape est réalisée par la détection de la longueur d'onde caractéristique λ₀ = 405 nm du nitrure de silicium et la mesure de l'amplitude d'émission optique du produit de gravure. On comprend en particulier que les valeurs de l'amplitude d'émission optique peuvent être mémorisées afin d'assurer le suivi de l'avancement du front de gravure précité.

A l'étape C, on dispose, après la mise en oeuvre de l'étape B, d'un ensemble de valeurs, lesquelles sont représentées en figure 3, ces valeurs constituant des valeurs d'amplitude d'émission optique en fonction du temps I(t) du produit de gravure.

Sur la figure 3, on a représenté une amplitude relative d'émission optique au cours de la gravure d'un substrat support d'une cellule mémoire EPROM pour une plaque n°1 et respectivement pour une plaque n°2 servant de plaque témoin. L'axe des ordonnées est gradué en valeurs d'amplitude relative et l'axe des abscisses en temps en secondes. La distribution D = I(t) représentant le tracé de l'émission optique en fonction du temps est alors une courbe de type "courbe en cloche". L'amplitude de l'émission augmente lors de l'apparition de la couche de nitrure, la deuxième couche d'oxyde, couche à mesurer, étant alors gravée, pour disparaître ensuite, lors de l'arrivée du front de gravure sur la première couche d'oxyde.

A l'étape C, on dispose ainsi d'une distribution temporelle de l'amplitude d'émission optique du produit de gravure, la distribution D = I(t).

En ce qui concerne l'étape D consistant à déterminer sur la distribution la position temporelle de la transition T de l'amplitude d'émission lors du passage du front de gravure de la couche à mesurer à la couche sous-jacente, on indique que cette détermination peut avantageusement être réalisée par mise en évidence d'une augmentation significative du niveau de l'amplitude d'émission en raison de ce passage.

En référence à la figure 3 précitée, on indique que pour la distribution considérée, le niveau d'amplitude d'émission optique en début de gravure, c'est-à-dire lors du processus de gravure de la couche correspondant à la grille de commande, correspond à une amplitude sensiblement constante de l'émission optique en raison de la discrimination réalisée par la longueur d'onde λ₀ caractéristique de la couche sous-jacente Si₃N₄.

L'augmentation significative peut alors, à titre d'exemple non limitatif, être prise égale à une augmentation de 50% de la valeur de l'amplitude d'émission optique lors de la gravure de la grille de commande, cette amplitude à l'origine constituant sensiblement une amplitude de référence pour la distribution D considérée.

On comprend ainsi qu'alors que l'amplitude de l'émission optique pour la grille de commande et pour la deuxième couche d'oxyde SiO₂ est sensiblement constante, la rencontre par le flanc de gravure de la couche sous-jacente Si₃N₄ provoque une augmentation brusque de l'amplitude d'émission en raison d'une émission optique importante dès la rencontre par le front de gravure de la couche sous-jacente précitée.

Ainsi, il est possible sur la distribution D précédemment mentionnée de définir un temps de gravure d'origine, noté t₀, et un temps t₁ pour lequel la couche sous-jacente précitée est réputée atteinte lors de l'atteinte par l'amplitude de l'émission optique de l'augmentation de 50% précédemment mentionnée.

L'étape D peut alors être suivie de l'étape E, laquelle consiste, à partir de la distribution D et de la transition T repérée par les instants t₀ et t₁, à calculer l'épaisseur de la couche à mesurer, c'est-à-dire de la deuxième couche d'oxyde, par corrélation entre la durée séparant le début de la gravure à l'instant t₀ et l'atteinte de la couche sous-jacente à l'instant t₁

Selon un aspect remarquable du procédé objet de la présente invention, on indique qu'en raison de la vitesse de gravure sensiblement constante de progression du front de gravure au travers des diverses couches rencontrées par ce dernier, la corrélation entre l'épaisseur de la couche à mesurer, notée e, à la position de la transition T sur la distribution D, peut avantageusement être conduite à partir d'une combinaison linéaire reliant le temps de gravure, c'est-à-dire la durée t₁-t₀, et l'épaisseur calculée, e, de la couche à mesurer. On comprend en effet que du fait de la discrimination de la longueur d'onde λ₀ associée à la couche sous-jacente, l'avènement de la transition T est suffisamment bref pour que, pour une vitesse de gravure sensiblement constante préalablement à cette transition, l'épaisseur effective de la couche à mesurer vérifie la combinaison linéaire précitée.

Bien entendu, les paramètres de la combinaison linéaire précédemment mentionnée peuvent être déterminés par étalonnage en fonction de la nature respective de la couche à mesurer et de la couche sous-jacente.

Un exemple de mise en oeuvre du calcul de l'épaisseur effective de la couche à mesurer lorsque cette couche est la deuxième couche d'oxyde de silicium précédemment mentionnée d'une cellule mémoire EPROM sera maintenant donné en liaison avec la figure 4.

En référence à la figure précitée, on indique que pour des conditions de gravure spécifiques, l'épaisseur effective de la deuxième couche d'oxyde de silicium vérifie la relation e = a.θ+β.
Dans la relation précédente, on indique que θ désigne la durée t₁-t₀ précédemment mentionnée, a représente une valeur de pente de la combinaison linéaire précitée, a = 1,16, et β représente l'ordonnée à l'origine sensiblement égale à β = 5,16. Les valeurs d'épaisseur effective obtenues sont données en nm pour une durée θ exprimée en secondes.

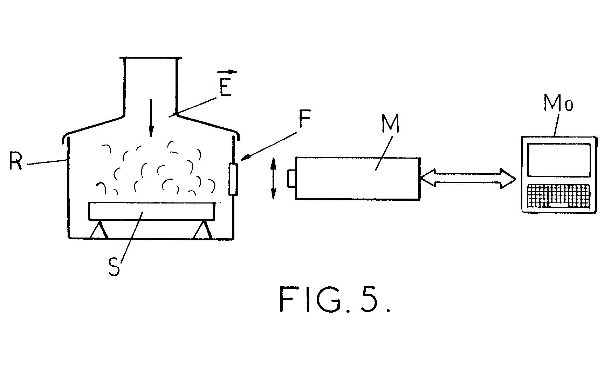

En ce qui concerne la mise en oeuvre du procédé objet de la présente invention, on indique que celle-ci peut être effectuée grâce à l'installation représentée en figure 5.

Alors que le réacteur R contient le substrat S soumis au processus de gravure par plasma, représenté par le champ électrique E, le réacteur R précité peut avantageusement être muni d'une fenêtre F en quartz permettant d'observer le produit de gravure au moyen d'un monochromateur M dont la longueur d'onde est centrée sur la valeur λ₀ précédemment mentionnée dans la description. Le monochromateur M peut alors être avantageusement relié à un micro-ordinateur MO permettant d'assurer la gestion des données de mesure d'amplitude d'émission optique du produit de gravure délivrée par le monochromateur M.

Le micro-ordinateur MO peut avantageusement comporter un logiciel d'acquisition des paramètres de la distribution D, en particulier la valeur de la durée θ précédemment mentionnée, cette acquisition étant bien entendu effectuée pendant le processus de gravure.

Enfin, un logiciel de calcul dans lequel peuvent être introduits des paramètres permettant de caractériser la couche à mesurer, la couche sous-jacente et la longueur d'onde associée à cette dernière permet, à partir d'une base de données spécifique, de déterminer les paramètres de la combinaison linéaire a et β et bien entendu de calculer directement l'épaisseur effective de la couche à mesurer.

On a ainsi décrit un procédé et une installation de mesure en temps réel de l'épaisseur d'une couche d'un circuit intégré particulièrement performants par le fait que la mesure de l'épaisseur de l'oxyde est effectuée au cours du processus de gravure du circuit intégré, c'est-à-dire en l'absence d'opérations déportées susceptibles de rallonger le processus de fabrication proprement dit, le procédé objet de la présente invention étant pour cette raison qualifié de procédé de mesure en temps réel. Ainsi, la mesure effective de l'épaisseur d'une couche à mesurer est effectuée lors du passage dans le réacteur de gravure directement sur la plaquette de production pour chaque substrat traité.

## Revendications

1. Procédé de mesure en temps réel de l'épaisseur d'une couche d'un circuit intégré, cette couche à mesurer étant déposée sur une couche sous-jacente, ce procédé étant conduit au cours d'une opération de gravure du substrat de ce circuit intégré incorporant ces couches, caractérisé en ce qu'il consiste :
- à suivre l'avancement du front de gravure de chaque couche de circuit intégré, par l'intermédiaire d'un tracé en temps réel du spectre d'émission optique du produit de la réaction de gravure sur au moins une composante spectrale de ladite couche sous-jacente ;
- à établir, en fonction du temps, une distribution de l'amplitude de l'émission optique du produit de la réaction de gravure ;
- à déterminer, sur cette distribution, la transition de l'amplitude de l'émission optique lors du passage du front de gravure, ladite couche à mesurer à ladite couche sous-jacente ;
- à calculer, à partir de ladite distribution et de ladite transition, l'épaisseur de ladite couche à mesurer, par corrélation à cette transition sur cette distribution.

2. Procédé selon la revendication 1, caractérisé en ce que ladite composante spectrale de ladite couche sous-jacente est une longueur d'onde d'émission remarquable caractéristique de ladite couche sous-jacente.

3. Procédé selon la revendication 1 ou 2, caractérisé en ce que la couche à mesurer étant constituée par la deuxième couche d'oxyde de silicium et la couche sous-jacente étant constituée par une couche d'arrêt en nitrure de silicium, ladite composante spectrale de ladite couche sous-jacente est la raie SiN à 405 nm.

4. Procédé selon l'une des revendications 1 à 3, caractérisé en ce que ladite corrélation, sur cette distribution, à la transition de l'amplitude d'émission optique est proportionnelle au temps de gravure séparant l'amplitude de l'émission optique en début de gravure, constituant une amplitude de référence, d'une augmentation de 50% de cette amplitude de référence sur ladite distribution.

5. Procédé selon la revendication 4, caractérisé en ce que le calcul de ladite épaisseur de ladite couche à mesurer est effectué à partir d'une combinaison linéaire reliant ledit temps de gravure et l'épaisseur calculée de la couche à mesurer.

6. Procédé selon l'une des revendications 1 à 5, caractérisé en ce que l'étape consistant à suivre l'avancement du front de gravure est effectuée au moyen d'un monochromateur.

7. Dispositif de mesure en temps réel de l'épaisseur d'une couche d'un circuit intégré, cette couche à mesurer étant déposée sur une couche sous-jacente, caractérisé en ce qu'il comporte au moins en combinaison :
- un réacteur de gravure d'un substrat de circuit intégré, ce réacteur étant muni d'une fenêtre optique F permettant l'observation optique du produit de gravure ;
- un monochromateur dont la longueur d'onde est centrée sur une valeur caractéristique de la couche sous-jacente permettant de délivrer des valeurs d'amplitude d'émission optique du produit de gravure ;
- des moyens de calcul de la position temporelle durée de l'atteinte de la couche sous-jacente par le front de gravure et de l'épaisseur effective de la couche à mesurer par combinaison linéaire reliant cette épaisseur à la durée de l'atteinte de la couche sous-jacente par le front de gravure.
